(19) Europäisches Patentamt
European Patent Office
Office européen des brevets

(11) EP 4 006 872 A1

(12) EUROPEAN PATENT APPLICATION

(43) Date of publication:
01.06.2022 Bulletin 2022/22

(51) International Patent Classification (IPC):
*G08G 1/0962* (2006.01)

(21) Application number: 21194764.3

(22) Date of filing: 03.09.2021

(52) Cooperative Patent Classification (CPC):
**G06K 9/6262; G06K 9/6289; G06T 7/20;
G06T 7/70; G06V 20/582; G08G 1/09623;**
G06T 2207/10016; G06T 2207/10021;
G06T 2207/10028; G06T 2207/10048;
G06T 2207/20021; G06T 2207/20081;
G06T 2207/20084; G06T 2207/30252

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: 27.11.2020 US 202017105689

(71) Applicant: INTEL Corporation
Santa Clara, CA 95054 (US)

(72) Inventors:
• POHL, Daniel
91093 Hessdorf (DE)
• FOX, Maik
76287 Rheinstetten (DE)

(74) Representative: Viering, Jentschura & Partner
mbB
Patent- und Rechtsanwälte
Am Brauhaus 8
01099 Dresden (DE)

(54) **METHODS, SYSTEMS, AND DEVICES FOR VERIFYING ROAD TRAFFIC SIGNS**

(57) A device includes one or more processors configured to obtain an image of a traffic sign, analyze the image to determine a traffic sign information, identify a verification information based on the traffic sign information, and verify the validity of the traffic sign information. Wherein verifying the validity of the traffic sign information includes: comparing the verification information to a further verification information, and determining whether the verification information is the same as the further verification information. Wherein the one or more processors are further configured to generate an instruction based on the determination. Wherein the one or more processors are further configured to obtain a further image of the traffic sign, and analyze the further image to determine a further traffic sign information, wherein the further traffic sign information includes the further verification information.

FIG 8A

EP 4 006 872 A1

## Description

### Technical Field

Various aspects of this disclosure generally relate to verifying road traffic signs in autonomous driving systems.

### Background

Autonomous driving utilizes reliable driving control and safety systems that process data acquired at a vehicle. Using data acquired at the vehicle, which may include data about the vehicle's external environment, internal environment, or data about the vehicle itself, the vehicle may alter its movements, modify its positioning with respect to external elements, and/or respond to newly detected events. Additionally, autonomous vehicles may be configured to communicate with other devices, such as other vehicles, network infrastructure elements, wireless devices, etc., to assist in the mobility control, provide faster information processing, and, generally speaking, communicate information in order to improve overall system performance.

Correctly identifying traffic signs within a vehicle's environment is a crucial task of advanced driver-assistance systems (ADAS) and autonomous driving (AD) technology. Human drivers may rely on driving rules and their own driving experiences when Identifying traffic signs. ADAS and AD technology may be vulnerable to false traffic signs. Identifying whether a traffics sign is valid or not is an area where ADAS/AD technology may be improved. ADAS/AD systems may interpret invalid traffic signs inserted into driving environments as valid. For example, a valid traffic signs may be vandalized and not detected or detected as a traffic sign with information that is different than what is displayed on the traffic. False and vandalized traffic sings may not affect human drivers, but they reliably spoof automated image recognition systems found in ADAS/AD technology.

Ensuring ADAS/AD systems perceive valid traffic signs may be a resource intensive task. Storing all traffic sign data in an ADAS/AD accessible database may be a reliable method of verifying traffic sign information. However, the sheer number of traffic signs and rate of update required may be too complicated to make it a feasible option. For example, temporary traffic signs would have to be added to the database and be removed when they are no longer in use.

### Brief Description of the Drawings

In the drawings, like reference characters generally refer to the same parts throughout the different views. The drawings are not necessarily to scale, emphasis instead generally being placed upon illustrating the principles of the disclosure. In the following description, various aspects of the disclosure are described with reference to the following drawings, in which:

FIG. 1 shows an exemplary autonomous vehicle in accordance with various aspects of the present disclosure.
FIG. 2 shows various exemplary electronic components of a safety system of the vehicle in accordance with various aspects of the present disclosure.
FIG. 3 shows an exemplary diagram of a vehicle according to some aspects.
FIG. 4 shows an exemplary diagram of a perception system according to some aspects.
FIG. 5 shows an exemplary diagram of a traffic sign verification system according to some aspects.
FIG. 6 shows an exemplary traffic sign according to some aspects.
FIG. 7 shows an exemplary traffic sign surface according to some aspects.
FIGs. 8A and 8B show exemplary detectable viewing angle ranges of a traffic sign according to some aspects.
FIG. 9 show exemplary detectable viewing angle ranges of a traffic sign according to some aspects.
FIG. 10 shows exemplary vehicle perceiving a traffic sign according to some aspects.
FIGs. 11 and 12 show exemplary methods of verifying a traffic sign according to some aspects.

### Description

Traffic signs may be modified or mimicked to reliably deceive ADAS and AD technology perceiving the traffic signs. ADAS/AD technology may rely on map data containing all traffic signs to avoid incorrectly perceiving a traffic sign. However, map data may be outdated. Ensuring reliable traffic sign detection and interpretation may be desirable.

The following detailed description refers to the accompanying drawings that show, by way of illustration, exemplary details and aspects in which the disclosure may be practiced.

The word "exemplary" is used herein to mean "serving as an example, instance, or illustration". Any aspect or design described herein as "exemplary" is not necessarily to be construed as preferred or advantageous over other aspects or designs.

Throughout the drawings, it should be noted that like reference numbers are used to depict the same or similar elements, features, and structures, unless otherwise noted.

The terms "at least one" and "one or more" may be understood to include a numerical quantity greater than or equal to one (e.g., one, two, three, four, [...], etc.). The term "a plurality" may be understood to include a numerical quantity greater than or equal to two (e.g., two, three, four, five, [...], etc.).

The words "plural" and "multiple" in the description and in the claims expressly refer to a quantity greater than one. Accordingly, any phrases explicitly invoking the aforementioned words (e.g., "plural [elements]", "multiple [elements]") referring to a quantity of elements expressly refers to more than one of the said elements. The phrases "group (of)", "set (of)", "collection (of)", "series (of)", "sequence (of)", "grouping (of)", etc., and the like in the description and in the claims, if any, refer to a quantity equal to or greater than one, i.e., one or more. The phrases "proper subset", "reduced subset", and "lesser subset" refer to a subset of a set that is not equal to the set, illustratively, referring to a subset of a set that contains less elements than the set.

The phrase "at least one of' with regard to a group of elements may be used herein to mean at least one element from the group including the elements. For example, the phrase "at least one of' with regard to a group of elements may be used herein to mean a selection of: one of the listed elements, a plurality of one of the listed elements, a plurality of individual listed elements, or a plurality of a multiple of individual listed elements.

The term "data" as used herein may be understood to include information in any suitable analog or digital form, e.g., provided as a file, a portion of a file, a set of files, a signal or stream, a portion of a signal or stream, a set of signals or streams, and the like. Further, the term "data" may also be used to mean a reference to information, e.g., in form of a pointer. The term "data", however, is not limited to the aforementioned examples and may take various forms and represent any information as understood in the art.

Any vector and/or matrix notation utilized herein is exemplary in nature and is employed solely for purposes of explanation. Accordingly, aspects of this disclosure accompanied by vector and/or matrix notation are not limited to being implemented solely using vectors and/or matrices, and that the associated processes and computations may be equivalently performed with respect to sets, sequences, groups, etc., of data, observations, information, signals, samples, symbols, elements, etc.

It is appreciated that any vector and/or matrix notation utilized herein is exemplary in nature and is employed solely for purposes of explanation. Accordingly, it is understood that the approaches detailed in this disclosure are not limited to being implemented solely using vectors and/or matrices, and that the associated processes and computations may be equivalently performed with respect to sets, sequences, groups, etc., of data, observations, information, signals, samples, symbols, elements, etc. Furthermore, it is appreciated that references to a "vector" may refer to a vector of any size or orientation, e.g. including a 1x1 vector (e.g. a scalar), a 1xM vector (e.g. a row vector), and an Mx1 vector (e.g. a column vector). Similarly, it is appreciated that references to a "matrix" may refer to matrix of any size or orientation, e.g. including a 1x1 matrix (e.g. a scalar), a 1xM matrix (e.g. a row vector), and an Mx1 matrix (e.g. a column vector).

The terms "processor" or "controller" as, for example, used herein may be understood as any kind of technological entity that allows handling of data. The data may be handled according to one or more specific functions executed by the processor or controller. Further, a processor or controller as used herein may be understood as any kind of circuit, e.g., any kind of analog or digital circuit, and may also be referred to as a "processing circuit," "processing circuitry," among others. A processor or a controller may thus be or include an analog circuit, digital circuit, mixed-signal circuit, logic circuit, processor, microprocessor, Central Processing Unit (CPU), Graphics Processing Unit (GPU), Digital Signal Processor (DSP), Field Programmable Gate Array (FPGA), integrated circuit, Application Specific Integrated Circuit (ASIC), etc., or any combination thereof. Any other kind of implementation of the respective functions, which will be described below in further detail, may also be understood as a processor, controller, or logic circuit. It is understood that any two (or more) of the processors, controllers, or logic circuits detailed herein may be realized as a single entity with equivalent functionality, among others , and conversely that any single processor, controller, or logic circuit detailed herein may be realized as two (or more) separate entities with equivalent functionality, among others.

As used herein, "memory" is understood as a computer-readable medium in which data or information can be stored for retrieval. References to "memory" included herein may thus be understood as referring to volatile or non-volatile memory, including random access memory (RAM), read-only memory (ROM), flash memory, solid-state storage, magnetic tape, hard disk drive, optical drive, among others, or any combination thereof. Registers, shift registers, processor registers, data buffers, among others, are also embraced herein by the term memory. The term "software" refers to any type of executable instruction, including firmware.

Unless explicitly specified, the term "transmit" encompasses both direct (point-to-point) and indirect transmission (via one or more intermediary points). Similarly, the term "receive" encompasses both direct and indirect reception. Furthermore, the terms "transmit," "receive," "communicate," and other similar terms encompass both physical transmission (e.g., the transmission of radio signals) and logical transmission (e.g., the transmission of digital data over a logical software-level connection). For example, a processor or controller may transmit or receive data over a software-level connection with another processor or controller in the form of radio signals, where the physical transmission and reception is handled by radio-layer components such as RF transceivers and antennas, and the logical transmission and reception over the software-level connection is performed by the processors or controllers. The term "communicate" encompasses one or both of transmitting and receiving, i.e., unidirectional or bidirectional communication in one or both of the incoming and outgoing directions. The term "calculate" encompasses both 'direct' calculations via a mathematical expression/formula/relationship and 'indirect' calculations via lookup or hash tables and other array indexing or searching operations.

A "vehicle" may be understood to include any type of driven or drivable object. By way of example, a vehicle may be a driven object with a combustion engine, a reaction engine, an electrically driven object, a hybrid driven object, or a combination thereof. A vehicle may be or may include an automobile, a bus, a mini bus, a van, a truck, a mobile home, a vehicle trailer, a motorcycle, a bicycle, a tricycle, a train locomotive, a train wagon, a moving robot, a personal transporter, a boat, a ship, a submersible, a submarine, a drone, an aircraft, a rocket, and the like.

A "ground vehicle" may be understood to include any type of vehicle, as described above, which is configured to traverse or be driven on the ground, e.g., on a street, on a road, on a track, on one or more rails, off-road, etc. An "aerial vehicle" may be understood to be any type of vehicle, as described above, which is capable of being maneuvered above the ground for any duration of time, e.g., a drone. Similar to a ground vehicle having wheels, belts, etc., for providing mobility on terrain, an "aerial vehicle" may have one or more propellers, wings, fans, among others, for providing the ability to maneuver in the air. An "aquatic vehicle" may be understood to be any type of vehicle, as described above, which is capable of being maneuvers on or below the surface of liquid, e.g., a boat on the surface of water or a submarine below the surface. It is appreciated that some vehicles may be configured to operate as one of more of a ground, an aerial, and/or an aquatic vehicle.

The term "autonomous vehicle" may describe a vehicle capable of implementing at least one navigational change without driver input. A navigational change may describe or include a change in one or more of steering, braking, or acceleration/deceleration of the vehicle. A vehicle may be described as autonomous even in case the vehicle is not fully automatic (e.g., fully operational with driver or without driver input). Autonomous vehicles may include those vehicles that can operate under driver control during certain time periods and without driver control during other time periods. Autonomous vehicles may also include vehicles that control only some aspects of vehicle navigation, such as steering (e.g., to maintain a vehicle course between vehicle lane constraints) or some steering operations under certain circumstances (but not under all circumstances), but may leave other aspects of vehicle navigation to the driver (e.g., braking or braking under certain circumstances). Autonomous vehicles may also include vehicles that share the control of one or more aspects of vehicle navigation under certain circumstances (e.g., hands-on, such as responsive to a driver input) and vehicles that control one or more aspects of vehicle navigation under certain circumstances (e.g., hands-off, such as independent of driver input). Autonomous vehicles may also include vehicles that control one or more aspects of vehicle navigation under certain circumstances, such as under certain environmental conditions (e.g., spatial areas, roadway conditions). In some aspects, autonomous vehicles may handle some or all aspects of braking, speed control, velocity control, and/or steering of the vehicle. An autonomous vehicle may include those vehicles that can operate without a driver. The level of autonomy of a vehicle may be described or determined by the Society of Automotive Engineers (SAE) level of the vehicle (e.g., as defined by the SAE, for example in SAE J3016 2018: Taxonomy and definitions for terms related to driving automation systems for on road motor vehicles) or by other relevant professional organizations. The SAE level may have a value ranging from a minimum level, e.g. level 0 (illustratively, substantially no driving automation), to a maximum level, e.g. level 5 (illustratively, full driving automation).

In the context of the present disclosure, "vehicle operation data" may be understood to describe any type of feature related to the operation of a vehicle. By way of example, "vehicle operation data" may describe the status of the vehicle such as the type of propulsion unit(s), types of tires or propellers of the vehicle, the type of vehicle, and/or the age of the manufacturing of the vehicle. More generally, "vehicle operation data" may describe or include static features or static vehicle operation data (illustratively, features or data not changing over time). As another example, additionally or alternatively, "vehicle operation data" may describe or include features changing during the operation of the vehicle, for example, environmental conditions, such as weather conditions or road conditions during the operation of the vehicle, fuel levels, fluid levels, operational parameters of the driving source of the vehicle, etc. More generally, "vehicle operation data" may describe or include varying features or varying vehicle operation data (illustratively, time-varying features or data).

Various aspects herein may utilize one or more machine learning models to perform or control functions of the vehicle (or other functions described herein). The term "model" as, for example, used herein may be understood as any kind of algorithm, which provides output data from input data (e.g., any kind of algorithm generating or calculating output data from input data). A machine learning model may be executed by a computing system to progressively improve performance of a specific task. In some aspects, parameters of a machine learning model may be adjusted during a training phase based on training data. A trained machine learning model may be used during an inference phase to make predictions or decisions based on input data. In some aspects, the trained machine learning model may be used to generate additional training data. An additional machine learning model may be adjusted during a second training phase based on the generated additional training data. A trained additional machine learning model may be used during an inference phase to make predictions or decisions based on input data.

The machine learning models described herein may take any suitable form or utilize any suitable technique (e.g., for training purposes). For example, any of the machine learning models may utilize supervised learning, semi-supervised learning, unsupervised learning, or reinforcement learning techniques.

In supervised learning, the model may be built using a training set of data including both the inputs and the corresponding desired outputs (illustratively, each input may be associated with a desired or expected output for that input). Each training instance may include one or more inputs and a desired output. Training may include iterating through training instances and using an objective function to teach the model to predict the output for new inputs (illustratively, for inputs not included in the training set). In semi-supervised learning, a portion of the inputs in the training set may be missing the respective desired outputs (e.g., one or more inputs may not be associated with any desired or expected output).

In unsupervised learning, the model may be built from a training set of data including only inputs and no desired outputs. The unsupervised model may be used to find structure in the data (e.g., grouping or clustering of data points), illustratively, by discovering patterns in the data. Techniques that may be implemented in an unsupervised learning model may include, e.g., self-organizing maps, nearest-neighbor mapping, k-means clustering, and singular value decomposition.

Reinforcement learning models may include positive or negative feedback to improve accuracy. A reinforcement learning model may attempt to maximize one or more objectives/rewards. Techniques that may be implemented in a reinforcement learning model may include, e.g., Q-learning, temporal difference (TD), and deep adversarial networks.

Various aspects described herein may utilize one or more classification models. In a classification model, the outputs may be restricted to a limited set of values (e.g., one or more classes). The classification model may output a class for an input set of one or more input values. An input set may include sensor data, such as image data, radar data, LIDAR data and the like. A classification model as described herein may, for example, classify certain driving conditions and/or environmental conditions, such as weather conditions, road conditions, and the like. References herein to classification models may contemplate a model that implements, e.g., any one or more of the following techniques: linear classifiers (e.g., logistic regression or naive Bayes classifier), support vector machines, decision trees, boosted trees, random forest, neural networks, or nearest neighbor.

Various aspects described herein may utilize one or more regression models. A regression model may output a numerical value from a continuous range based on an input set of one or more values (illustratively, starting from or using an input set of one or more values). References herein to regression models may contemplate a model that implements, e.g., any one or more of the following techniques (or other suitable techniques): linear regression, decision trees, random forest, or neural networks.

A machine learning model described herein may be or may include a neural network. The neural network may be any kind of neural network, such as a convolutional neural network, an autoencoder network, a variational autoencoder network, a sparse autoencoder network, a recurrent neural network, a deconvolutional network, a generative adversarial network, a forward-thinking neural network, a sum-product neural network, and the like. The neural network may include any number of layers. The training of the neural network (e.g., adapting the layers of the neural network) may use or may be based on any kind of training principle, such as backpropagation (e.g., using the backpropagation algorithm).

Throughout the present disclosure, the following terms may be used as synonyms: driving parameter set, driving model parameter set, safety layer parameter set, driver assistance, automated driving model parameter set, and/or the like (e.g., driving safety parameter set). These terms may correspond to groups of values used to implement one or more models for directing a vehicle to operate according to the manners described herein.

Furthermore, throughout the present disclosure, the following terms may be used as synonyms: driving parameter, driving model parameter, safety layer parameter, driver assistance and/or automated driving model parameter, and/or the like (e.g., driving safety parameter), and may correspond to specific values within the previously described sets.

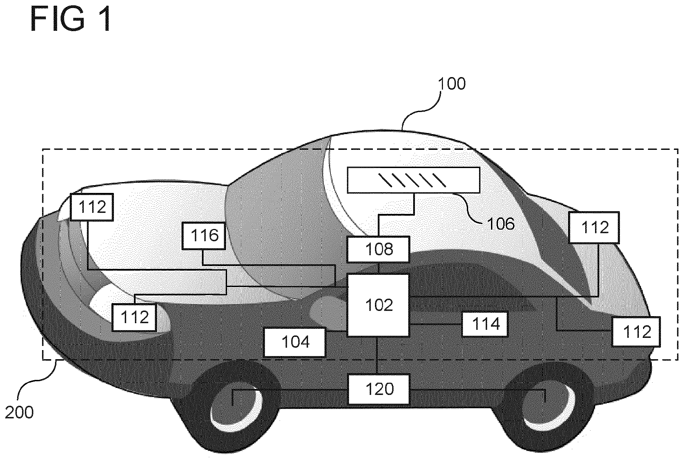

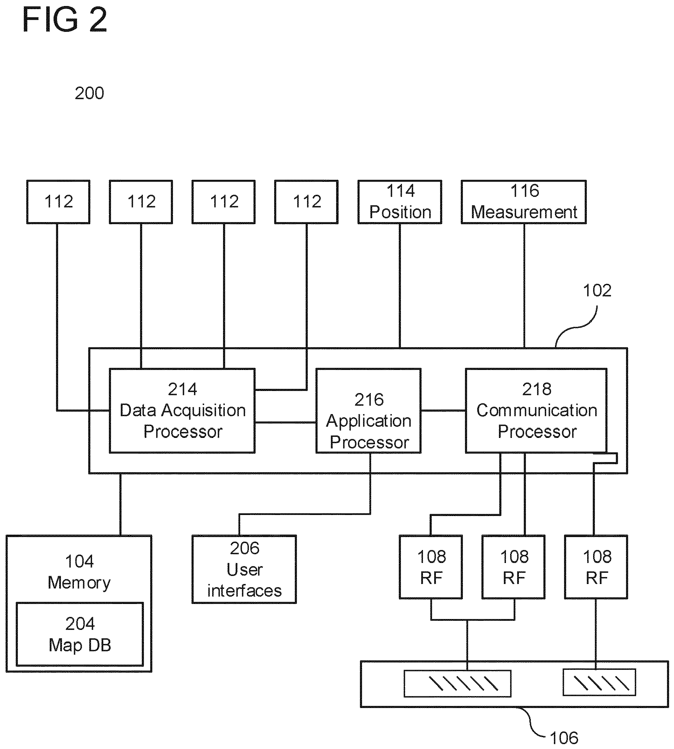

FIG. 1 shows a vehicle 100 including a mobility system 120 and a control system 200 (see also FIG. 2) in accordance with various aspects. It is appreciated that vehicle 100 and control system 200 are exemplary in nature and may thus be simplified for explanatory purposes. For example, while vehicle 100 is depicted as a ground vehicle, aspects of this disclosure may be equally or analogously applied to aerial vehicles such as drones or aquatic vehicles such as boats. Furthermore, the quantities and locations of elements, as well as relational distances (as discussed above, the figures are not to scale) are provided as examples and are not limited thereto. The components of vehicle 100 may be arranged around a vehicular housing of vehicle 100, mounted on or outside of the vehicular housing, enclosed within the vehicular housing, or any other arrangement relative to the vehicular housing where the components move with vehicle 100 as it travels. The vehicular housing, such as an automobile body, drone body, plane or helicopter fuselage, boat hull, or similar type of vehicular body, is dependent on the type of vehicle that vehicle 100 is.

In addition to including a control system 200, vehicle 100 may also include a mobility system 120. Mobility system 120 may include components of vehicle 100 related to steering and movement of vehicle 100. In some aspects, where vehicle 100 is an automobile, for example, mobility system 120 may include wheels and axles, a suspension, an engine, a transmission, brakes, a steering wheel, associated electrical circuitry and wiring, and any other components used in the driving of an automobile. In some aspects, where vehicle 100 is an aerial vehicle, mobility system 120 may include one or more of rotors, propellers, jet engines, wings, rudders or wing flaps, air brakes, a yoke or cyclic, associated electrical circuitry and wiring, and any other components used in the flying of an aerial vehicle. In some aspects, where vehicle 100 is an aquatic or sub-aquatic vehicle, mobility system 120 may include any one or more of rudders, engines, propellers, a steering wheel, associated electrical circuitry and wiring, and any other components used in the steering or movement of an aquatic vehicle. In some aspects, mobility system 120 may also include autonomous driving functionality, and accordingly may include an interface with one or more processors 102 configured to perform autonomous driving computations and decisions and an array of sensors for movement and obstacle sensing. In this sense, the mobility system 120 may be provided with instructions to direct the navigation and/or mobility of vehicle 100 from one or more components of the control system 200. The autonomous driving components of mobility system 120 may also interface with one or more radio frequency (RF) transceivers 108 to facilitate mobility coordination with other nearby vehicular communication devices and/or central networking components that perform decisions and/or computations related to autonomous driving.

The control system 200 may include various components depending on the requirements of a particular implementation. As shown in FIG. 1 and FIG. 2, the control system 200 may include one or more processors 102, one or more memories 104, an antenna system 106 which may include one or more antenna arrays at different locations on the vehicle for radio frequency (RF) coverage, one or more radio frequency (RF) transceivers 108, one or more data acquisition devices 112, one or more position devices 114 which may include components and circuitry for receiving and determining a position based on a Global Navigation Satellite System (GNSS) and/or a Global Positioning System (GPS), and one or more measurement sensors 116, e.g. speedometer, altimeter, gyroscope, velocity sensors, etc.

The control system 200 may be configured to control the vehicle's 100 mobility via mobility system 120 and/or interactions with its environment, e.g. communications with other devices or network infrastructure elements (NIEs) such as base stations, via data acquisition devices 112 and the radio frequency communication arrangement including the one or more RF transceivers 108 and antenna system 106.

The one or more processors 102 may include a data acquisition processor 214, an application processor 216, a communication processor 218, and/or any other suitable processing device. Each processor 214, 216, 218 of the one or more processors 102 may include various types of hardware-based processing devices. By way of example, each processor 214, 216, 218 may include a microprocessor, pre-processors (such as an image preprocessor), graphics processors, a central processing unit (CPU), support circuits, digital signal processors, integrated circuits, memory, or any other types of devices suitable for running applications and for image processing and analysis. In some aspects, each processor 214, 216, 218 may include any type of single or multi-core processor, mobile device microcontroller, CPU, etc. These processor types may each include multiple processing units with local memory and instruction sets. Such processors may include video inputs for receiving image data from multiple image sensors and may also include video out capabilities.

Any of the processors 214, 216, 218 disclosed herein may be configured to perform certain functions in accordance with program instructions which may be stored in a memory of the one or more memories 104. In other words, a memory of the one or more memories 104 may store software that, when executed by a processor (e.g., by the one or more processors 102), controls the operation of the system, e.g., a driving and/or safety system. A memory of the one or more memories 104 may store one or more databases and image processing software, as well as a trained system, such as a neural network, or a deep neural network, for example. The one or more memories 104 may include any number of random-access memories, read only memories, flash memories, disk drives, optical storage, tape storage, removable storage and other types of storage. Alternatively, each of processors 214, 216, 218 may include an internal memory for such storage.

The data acquisition processor 214 may include processing circuity, such as a CPU, for processing data acquired by data acquisition units 112. For example, if one or more data acquisition units are image acquisition units, e.g. one or more cameras, then the data acquisition processor may include image processors for processing image data using the information obtained from the image acquisition units as an input. The data acquisition processor 214 may therefore be configured to create voxel maps detailing the surrounding of the vehicle 100 based on the data input from the data acquisition units 112, i.e., cameras in this example.

Application processor 216 may be a CPU, and may be configured to handle the layers above the protocol stack, including the transport and application layers. Application processor 216 may be configured to execute various applications and/or programs of vehicle 100 at an application layer of vehicle 100, such as an operating system (OS), a user interfaces (UIs) 206 for supporting user interaction with vehicle 100, and/or various user applications. Application processor 216 may interface with communication processor 218 and act as a source (in the transmit path) and a sink (in the receive path) for user data, such as voice data, audio/video/image data, messaging data, application data, basic Internet/web access data, etc.

In the transmit path, communication processor 218 may therefore receive and process outgoing data provided by application processor 216 according to the layer-specific functions of the protocol stack, and provide the resulting data to digital signal processor 208. Communication processor 218 may then perform physical layer processing on the received data to produce digital baseband samples, which digital signal processor may provide to RF transceiver(s) 108. RF transceiver(s) 108 may then process the digital baseband samples to convert the digital baseband samples to analog RF signals, which RF transceiver(s) 108 may wirelessly transmit via antenna system 106. In the receive path, RF transceiver(s) 108 may receive analog RF signals from antenna system 106 and process the analog RF signals to obtain digital baseband samples. RF transceiver(s) 108 may provide the digital baseband samples to communication processor 218, which may perform physical layer processing on the digital baseband samples. Communication processor 218 may then provide the resulting data to other processors of the one or more processors 102, which may process the resulting data according to the layer-specific functions of the protocol stack and provide the resulting incoming data to application processor 216. Application processor 216 may then handle the incoming data at the application layer, which can include execution of one or more application programs with the data and/or presentation of the data to a user via one or more user interfaces 206. User interfaces 206 may include one or more screens, microphones, mice, touchpads, keyboards, or any other interface providing a mechanism for user input or communication to the user (e.g., notifications to the user). Although various practical designs may include separate communication components for each supported radio communication technology (e.g., a separate antenna, RF transceiver, digital signal processor, and controller), for purposes of conciseness, the configuration of vehicle 100 shown in FIGs. 1 and 2 may depict only a single instance of such components.

Communication processor 218 may be configured to implement one or more vehicle-to-everything (V2X) communication protocols, which may include vehicle-to-vehicle (V2V), vehicle-to-infrastructure (V2I), vehicle-to-network (V2N), vehicle-to-pedestrian (V2P), vehicle-to-device (V2D), vehicle-to-grid (V2G), and other protocols. Communication processor 218 may be configured to transmit communications including communications (one-way or two-way) between the vehicle 100 and one or more other (target) vehicles in an environment of the vehicle 100 (e.g., to facilitate coordination of navigation of the vehicle 100 in view of or together with other (target) vehicles in the environment of the vehicle 100), or even a broadcast transmission to unspecified recipients in a vicinity of the transmitting vehicle 100.

Memory 214 may embody a memory component of vehicle 100, such as a hard drive or another such permanent memory device. Although not explicitly depicted in FIGs. 1 and 2, the various other components of vehicle 100, e.g. one or more processors 102, shown in FIGs. 1 and 2 may additionally each include integrated permanent and non-permanent memory components, such as for storing software program code, buffering data, etc.

Data acquisition devices 112 may include any number of data acquisition devices and components depending on the requirements of a particular application. This may include: image acquisition devices, proximity detectors, acoustic sensors, infrared sensors, piezoelectric sensors, etc., for providing data about the vehicle's environment (both outside and inside the vehicle). Image acquisition devices may include cameras (e.g., standard cameras, digital cameras, video cameras, single-lens reflex cameras, infrared cameras, stereo cameras, etc.), charge coupling devices (CCDs) or any type of image sensor. Proximity detectors may include radar sensors, light detection and ranging (LIDAR) sensors, mmWave radar sensors, etc. Acoustic sensors may include: microphones, sonar sensors, ultrasonic sensors, etc. Accordingly, each of the data acquisition units may be configured to observe a particular type of data of the vehicle's 100 environment and forward the data to the data acquisition processor 214 in order to provide the vehicle with an accurate portrayal of the vehicle's environment. The data acquisition devices 112 may be configured to implement preprocessed sensor data, such as radar target lists or LIDAR target lists, in conjunction with acquired data.

Measurement devices 116 may include other devices for measuring vehicle-state parameters, such as a velocity sensor (e.g., a speedometer) for measuring a velocity of the vehicle 100, one or more accelerometers (either single axis or multi-axis) for measuring accelerations of the vehicle 100 along one or more axes, a gyroscope for measuring orientation and/or angular velocity, odometers, altimeters, thermometers, etc. It is appreciated that vehicle 100 may have different measurement devices 116 depending on the type of vehicle it is, e.g., car vs. drone vs. boat.

One or more position devices 114 may include components for determining a position of the vehicle 100. For example, this may include global position system (GPS) or global navigation satellite system (GNSS) circuitry configured to receive signals from a satellite system and determine a position of the vehicle 100. Position devices 114, accordingly, may provide vehicle 100 with satellite navigation features.

The one or more memories 104 may store data, e.g., in a database or in any different format, that may correspond to a map. For example, the map may indicate a location of known landmarks, roads, paths, network infrastructure elements, or other elements of the vehicle's 100 environment. The one or more processors 102 may process sensory information (such as images, radar signals, depth information from LIDAR, or stereo processing of two or more images) of the environment of the vehicle 100 together with position information, such as one or more GPS coordinates, a vehicle's ego-motion, etc., to determine a current location of the vehicle 100 relative to the known landmarks, and refine the determination of the vehicle's location. Certain aspects of this technology may be included in a localization technology such as a mapping and routing model.

The map database (DB) 204 may include any type of database storing (digital) map data for the vehicle 100, e.g., for the control system 200. The map database 204 may include data relating to the position, in a reference coordinate system, of various items, including roads, water features, geographic features, businesses, points of interest, restaurants, gas stations, etc. The map database 204 may store not only the locations of such items, but also descriptors relating to those items, including, for example, names associated with any of the stored features. In some aspects, a processor of the one or more processors 102 may download information from the map database 204 over a wired or wireless data connection to a communication network (e.g., over a cellular network and/or the Internet, etc.). In some cases, the map database 204 may store a sparse data model including polynomial representations of certain road features (e.g., lane markings) or target trajectories for the vehicle 100. The map database 204 may also include stored representations of various recognized landmarks that may be provided to determine or update a known position of the vehicle 100 with respect to a target trajectory. The landmark representations may include data fields such as landmark type, landmark location, among other potential identifiers.

Furthermore, the control system 200 may include a driving model, e.g., implemented in an advanced driving assistance system (ADAS) and/or a driving assistance and automated driving system. By way of example, the control system 200 may include (e.g., as part of the driving model) a computer implementation of a formal model such as a safety driving model. A safety driving model may be or include a mathematical model formalizing an interpretation of applicable laws, standards, policies, etc. that are applicable to self-driving vehicles. A safety driving model may be designed to achieve, e.g., three goals: first, the interpretation of the law should be sound in the sense that it complies with how humans interpret the law; second, the interpretation should lead to a useful driving policy, meaning it will lead to an agile driving policy rather than an overly-defensive driving which inevitably would confuse other human drivers and will block traffic and in turn limit the scalability of system deployment; and third, the interpretation should be efficiently verifiable in the sense that it can be rigorously proven that the self-driving (autonomous) vehicle correctly implements the interpretation of the law. A safety driving model, illustratively, may be or include a mathematical model for safety assurance that enables identification and performance of proper responses to dangerous situations such that self-perpetrated accidents can be avoided.

As described above, the vehicle 100 may include the control system 200 as also described with reference to FIG. 2. The vehicle 100 may include the one or more processors 102 integrated with or separate from an electronic control unit (ECU) which may be included in the mobility system 120 of the vehicle 100. The control system 200 may, in general, generate data to control or assist to control the ECU and/or other components of the vehicle 100 to directly or indirectly control the movement of the vehicle 100 via mobility system 120. The one or more processors 102 of the vehicle 100 may be configured to implement the aspects and methods described herein.

The components illustrated in FIGs. 1 and 2 may be operatively connected to one another via any appropriate interfaces. Furthermore, it is appreciated that not all the connections between the components are explicitly shown, and other interfaces between components may be covered within the scope of this disclosure.

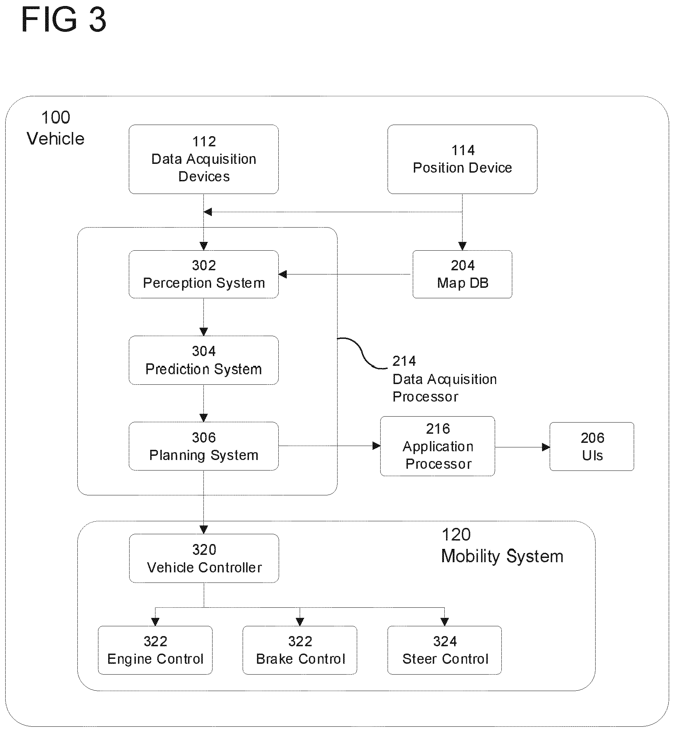

FIG. 3 shows an exemplary block diagram 300 of a vehicle 100 with a focus placed on several components according to some aspects. Vehicle 100 may be capable of sensing its environment and/or sense changes inside the vehicle and navigate without direct human input and/or provide notifications to occupants of the vehicle.

The one or more data acquisition processors 214 may include a perception system 302, a prediction system 304, and a planning system 306 that cooperate to perceive the external (i.e., outside of the vehicle) and/or internal (i.e., inside of the vehicle) environment of vehicle 100 and determine a plan for controlling the mobility or positioning of vehicle 100 and/or issue notifications to one or more occupants.

The perception system 302 can receive data from the one or more data acquisition devices 112 that are coupled to or otherwise included within the vehicle 100. As examples, the one or more data acquisition devices 112 may include one or more cameras to provide data in one or more modalities (e.g., color, infrared, depth, etc.), a LIDAR system, a radar system, and/or other data acquisition devices. The data can include information that describes the location of objects within the surrounding and/or internal environment of vehicle 100.

For example, for one or more cameras, various processing techniques (e.g., range imaging techniques such as, for example, structure from motion, structured light, stereo triangulation, and/or other techniques) can be performed to identify the location (e.g., in three-dimensional space relative to the one or more cameras) of a number of points that correspond to objects that are depicted in imagery captured by the one or more cameras. Other sensor systems can identify the location of points that correspond to objects as well.

The one or more position devices 114 may be any device or circuitry for determining the position of vehicle 100 (e.g., GPS, GNSS, triangulation methods with respect to terrestrial communication devices, etc.) and provide information to map DB 204 and/or perception system 302.

The data acquisition devices 112 and position devices 114 may therefore be used to collect data that includes information that describes the location (e.g., in three-dimensional space relative to vehicle 100) of points that correspond to objects within the surrounding and/or internal environment of vehicle 100.

In addition to the data from one or more data acquisition devices 112, the perception system 302 may retrieve or otherwise obtain map data from the map DB 204 that provides detailed information about the surrounding environment of the vehicle 100. The map DB 204 data may provide information regarding: the identity and location of different travel paths (e.g., roadways), road segments, buildings, or other items or objects (e.g., street lights, crosswalks, etc.); the location and directions of traffic lanes (e.g., the location and direction of a parking lane, a turning lane, a bicycle lane, or other lanes within a particular road); traffic control data (e.g., the location and instructions of signage, traffic lights, or other traffic control devices); and/or any other map data that provides information that assists the one or more processors 102 of vehicle 100 in monitoring and communicating with its external and/or internal environment.

The perception system 302 may identify one or more objects/features that may affect the control of vehicle 100 based on data received from the one or more one or more data acquisition devices 112 and/or the map DB 204. For example, according to some aspects, the perception system 302 may monitor an internal environment of the vehicle 100 and determine, for each object/feature, state data that describes a current state of such object as described. As examples, the state data for each object may describe an estimate of the object's: current location or position; current speed or velocity; current acceleration; current heading; current orientation; size/footprint (e.g., as represented by a bounding shape such as a bounding polygon or polyhedron); yaw rate; and/or other state information. According to some aspects, the perception system 302 may determine state data for each object/feature over a number of iterations and/or frames. In particular, the perception system 302 may update the state data for each object at each iteration or frame. Thus, the perception system 302 may detect and track objects and/or features (e.g., external to the vehicle such as other vehicles, internal to the vehicle such as people, etc.) over time. The perception system 302 may implement one or more machine learning models in order to perform these tasks.

The prediction system 304 may receive the state data from the perception system 302 and predict one or more future locations for each object based on such state data. For example, the prediction system 304 may predict where each object will be located within the next 1 second, 2 seconds, 10 seconds, etc. For example, an object may be predicted to adhere to its current trajectory according to its current velocity and/or acceleration. However, other more sophisticated prediction techniques or modeling may be implemented.

The planning system 306 may determine one or more plans for the vehicle 100 based at least in part on the perceived and/or predicted one or more future locations for the object and/or the state data for the object provided by the perception system 302 or prediction system 304. In other words, given information about the current locations of perceived objects and/or predicted future locations of the perceived objects, the planning system 306 may determine a plan for the vehicle 100 that best responds to or navigates the vehicle 100 relative to the objects at their current and/or future locations.

The planning system 306 may provide a plan to a vehicle controller 320 of the mobility system 120 that controls one or more vehicle controls such as Engine Control 322, Brake Control 324, and/or Steer Control 326 to execute the plan. The vehicle controller 320 may generate one or more vehicle control signals for the autonomous vehicle based at least in part on an output of the planning system 306. The planning system 306 may additionally or alternatively provide a notification to the Application Processor 216 to communicate via one or more UIs 206.

Each of the perception system 302, the prediction system 304, the planning system 306, and the vehicle controller 320 may include computer logic utilized to provide the desired functionality as discussed herein. According to some aspects, each of the perception system 302, the prediction system 304, the planning system 306, and the vehicle controller 320 may be implemented in hardware, firmware, and/or software controlling a general-purpose processor. For example, according to some aspects, each of the perception system 302, the prediction system 304, the planning system 306, and the vehicle controller 320 may include program instructions or files stored on a storage device, loaded into a memory and executed by one or more processors. In other aspects, each of the perception system 302, the prediction system 304, the planning system 306, and the vehicle controller 320 may include one or more sets of computer-executable instructions that are stored in a non-transitory computer-readable storage medium.

In various implementations, one or more of perception system 302, the prediction system 304, and/or the planning system 306 can include, or otherwise leverage, one or more machine learning models such as, for example, convolutional neural networks.

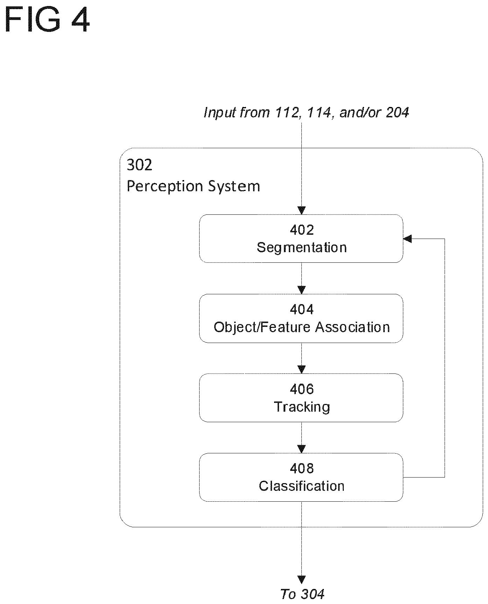

FIG. 4 shows an exemplary block diagram 400 providing further details of perception system 302 according to some aspects. As discussed in FIG. 3, one or more processors 102 in the data acquisition processor 214 may include a perception system 302 that may identify and/or track one or more objects and/or features (either in an external environment or internal environment) that may affect vehicle 100.

According to some aspects, the perception system 302 may include a segmentation component 402, an object/feature association component 404, a tracking component 406, and a classification component 408. The perception system 302 may receive data from one or more data acquisition devices 112, one or more position devices 114, and/or map data from map DB 204 as input. The perception system 302 may use these inputs in determining objects and/or behaviors of different objects in the external and/or internal environment to the vehicle 100. According to some aspects, the perception system 302 may iteratively processes the input data to detect, track, and classify objects identified from the input data.

The segmentation component 402 may process the received input data to determine potential objects and/or features within the external and/or internal environment, for example, using one or more object detection systems. The object/feature association component 404 may receive data about the determined objects and/or features and analyze prior object/feature instance data to determine a most likely association of each determined object/feature with a prior object/feature instance, or in some cases, determine if the potential object/feature is a new object/feature instance. The tracking component 406 may determine the current state of each object/feature instance, for example, in terms of its current position, velocity, acceleration, heading, orientation, uncertainties, and/or the like. The tracking component 406 may be further configured to track a change in state of an object/feature over time, e.g., over multiple video frames provided by one or more cameras. The classification component 408 may receive the data from tracking component 406 and classify each of the object/feature instances. For example, classification component 408 may classify a tracked object/feature as an object/feature from a predetermined set of objects/features and actions taken based on the tracked objects/features, e.g., driver in alert position, driver texting, etc. Classification component 408 may also provide feedback for the training of the segmentation component 402.

Perception system 302 may provide the object/feature and state data for use by various other systems within vehicle 100, such as prediction system 304.

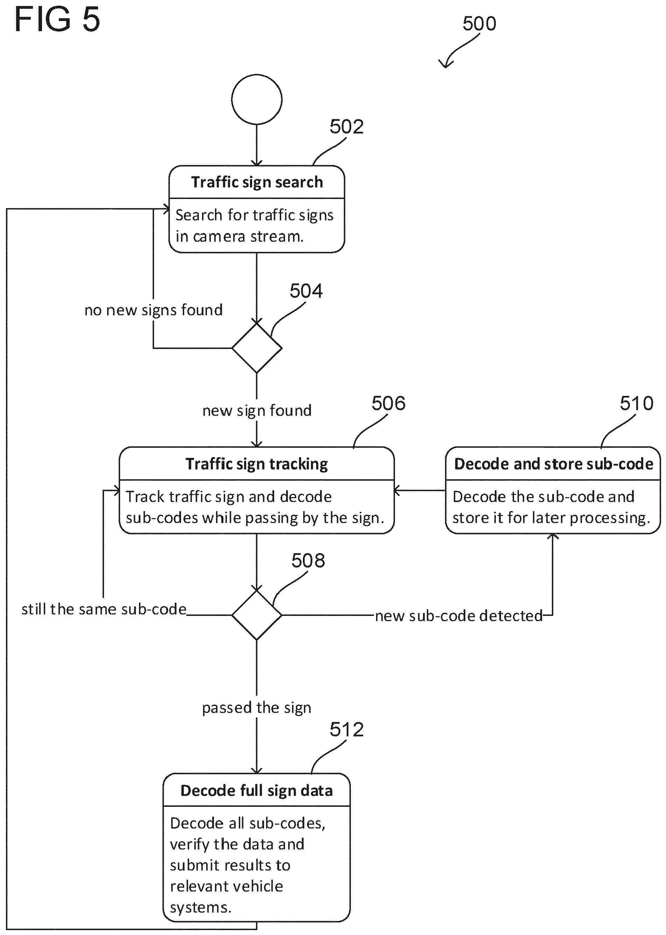

FIG. 5 shows an exemplary flow diagram of traffic sign verification method 500. One or more processors of autonomous vehicle may be configured to execute traffic sign verification method 500 as described below. The traffic sign verification method 500 may interface with an ADAS/AD system to reliably verify traffic sign information. The traffic sign verification method 500 may search image sensor data to identify images of traffic signs within a vehicle environment in stage 502. For example, the perception system 302 may identify traffic signs within the vehicle environment. The method may keep track of the identified traffic sign images and determine if a new traffic sign has been identified in stage 504. If a new traffic sign is identified, the traffic sign image of the new traffic sign is stored in stage 506. The method determines if the traffic sign image of the traffic sign is new as compared to previously stored traffic sign images of the traffic sign in stage 508. If the traffic sign image is the not new, the method returns to stage 506. If the traffic sign image is new, the method moves to stage 510 to analyze the traffic sign image and determine traffic sign information in stage 510. The traffic sign information may include verification information. The traffic sign information and verification information may be stored at stage 506. If there are no more new images of the traffic sign, the method determines that the vehicle has passed the traffic sign in stage 508 and moves to stage 512. The method compares the verification information of the different traffic sign images and determines if the traffic sign information is valid based on the comparison in stage 512. The method may then generate a vehicle instruction based on the verified traffic sign information.

ADAS/AD systems may interface with traffic sign verification methods to perceive traffic signs configured to display traffic sign information and verify the traffic sign information. Traffic signs may be configured to display traffic sign information including verification information. The traffic sign information may be displayed on the traffic sign displays in human and machine readable formats. Machine readable traffic sign information may be encoded into the traffic sign display. The encoded traffic sign information may include a verification information used to verify the sign information. This may be accomplished offline and without map data. However, map data may be used to confirm the verified traffic sign information. Traffic signs may be configured to show different traffic sign information at different detectable viewing angle ranges. This may require an ADAS/AD equipped vehicle to drive passed a traffic sign to completely read all of the traffic sign information.

Traffic signs configured to display changing traffic sign information may be verified by ADAS/AD equipped vehicles without depending on up-to-date map data or an active mobile data connection. The verification information included in the traffic sign information makes such traffic signs less vulnerable to attacks.

Verified traffic sign information may be confirmed with map data and or databases storing traffic sign information. For example, a verified traffic information may be compared with map data. If the map data does not corroborate the verified traffic sign information, the method may determine if the map data is old. If the map data is old, the verified traffic sign information may be more reliable. However, if the verified traffic sign information is compared with map data or a database and found to be corroborated, the ADAS/AD system can trust the verified traffic sign information with higher level of confidence than without the verified traffic sign information.

The method of traffic sign information verification adds a credibility mechanism to crowdsourced map data and can account for the continuously changing traffic sign landscape. For example, temporary traffic signs in construction zones. Furthermore, initial survey and database creation would benefit from additional meta data gathered with the method of traffic sign information verification.

The method allows for offline verification of traffic sign information. This allows the ADAS/AD system to verify traffic sign information without dependency on mobile data coverage or map data.

The method of traffic sign information verification may work in combination with real time on line verification. Obtained traffic sign images may be processed in the cloud when there is a mobile data connection. If an ADAS/AD system traffic sign detection using neural networks comes to one result and the method of traffic sign information verification shown in the present disclosure comes to a different conclusion asynchronously, the discrepancy may be valuable data that can be acted upon.

An ADAS/AD system may include a method for verifying traffic sign information as described in the present disclosure. The method may analyze traffic sign images captured by image sensors of the ADAS/AD system. The method for verifying traffic sign information may search for traffic signs in a video or image stream. The method may limit its search to traffic signs perceived from a forward-looking image sensor. The method may track identified traffic signs as a vehicle moves forward. Traffic sign displays may include verification information in codes within the traffic sign display as described below. For example, a QR like codes may be included in the traffic sign display. The traffic sign information may change depending on its viewing angle range. The method may track and store the different detected traffic sign information. The different traffic sign information is processed to determine a verification information. The verification information is used to determine with a high degree of confidence whether the traffic sign information is valid or that the traffic sign was manipulated.

Traffic signs may be manipulated to deceive ADAS/AD systems into perceiving incorrect traffic signs. For example, strategically placing tape over existing traffic signs may deceive an ADAS/AD system into perceiving a speed limit sign as a stop sign. However, strategically placed tape may not emulate a traffic sign display displaying different traffic sign information at different viewing angle ranges. The traffic sign information verification method would be able to detect that a traffic sign was manipulated because the method may determine that the verification information from the different traffic sign information does not reconcile. If strategically placed tape would be able to emulated the different traffic sign information at different viewing angle ranges, the traffic sign information may overcome an attack with a public/private key signing system.

Projectors may project images of traffic signs to deceive ADAS/AD systems. However, the projection would have to change depending on the viewing angle range and would require actively tracking a single vehicle by the projector system such as a drone. Again, including a public/private key system in the traffic sign display would limit projector attacks.

While autonomous vehicles traffic sign databases, as long as they share the roads with human drivers, both should use the same data source to navigate the roads, and the primary data source are physical traffic signs.

Traffic signs may continue to be an important part of traffic regulations as long as human driven and autonomous vehicles coexist. All participants on the road need to have the identical understanding of the applicable rules and limits. While not all traffic signs would be renewed at the same time, signs at accident prone locations may be replaced first, until all signs are replaced at some time in the future.

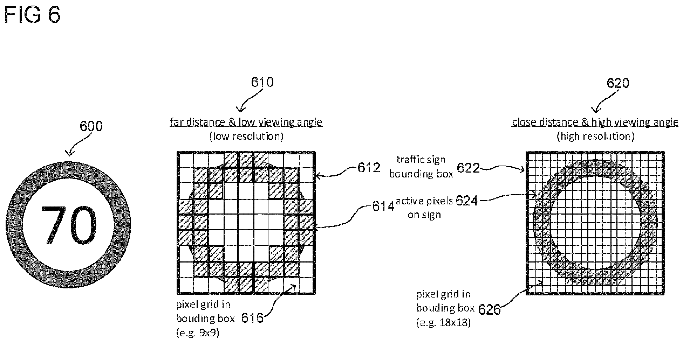

FIG. 6 shows an exemplary traffic sign 600. Traffic sign 600 may be configured to display different traffic sign information at detectable viewing angle ranges. Perception system 302 may analyze images of traffic sign 600 to determine that an image is a traffic sign. For example, traffic sign image 610 may be a traffic sign image taken from a larger distance as compared to traffic sign image 620. Because traffic sign image 610 may have been taken from a farther distance than traffic sign image 620, the resolution of traffic sign image 610 may be smaller than the resolution of traffic sign image 620. Traffic sign 600 may be configured to display more traffic sign information at a higher resolution image as compared to a lower resolution image. For example, traffic sign image 610 may include bounding box 612. Bounding box 612 may include a 9 by 9 pixel grid 616. Traffic sign 600 may be configured to embed traffic sign information within a displayed image at a specific resolution and viewing angle range. The pixels at the resolution of traffic sign image 610 may embed traffic sign information at active pixels 614. Traffic sign image 620 may include bounding box 622. Bounding box 622 may include a 18 by 18 pixel grid 626. Traffic sign 600 may be configured to embed traffic sign information within a displayed image at a higher resolution and at second viewing angle range. The pixels at the resolution of traffic sign image 620 may embed traffic sign information at active pixels 624. Because the resolution of traffic sign image 620 is larger than the resolution of traffic sign image 610, traffic sign image 620 includes a larger number of pixels. The larger number of pixels enables more traffic sign information to be embedded within an image.

Configuring traffic signs to display traffic sign information in a human readable form and a machine-readable form may include a traffic sign display image and an embedded code. The embedded code may include traffic sign information and be dependent on the viewing angle range. The traffic sign information may include verification information to verify the traffic sign information and/or traffic sign location.

The embedded codes for displaying traffic sign information may be a fully custom code or extend existing standardized codes such as QR code, Data Matrix Code, Aztec Code, etc.

A traffic sign may be configured to use a QR-like code to display traffic sign information. For example, the traffic sign information may include codes which are divided among pixels of a traffic sign image. Each code of the traffic sign may consist of a certain number of pixels. Each pixel may represent a digital value of 0 or 1 based on the color or colors displayed in the pixel. The pixel values may not be identical across the different traffic sign information displayed.

For example, a traffic sign configured to display 3 different traffic sign information. The different traffic sign information may be embedded using a Micro-QR code. The traffic sign information may include a traffic sign type ID, orientation, latitude, longitude, unique ID, verification key, etc.

A first traffic sign information may be configured for large distance, low resolution, and low information density according to a Micro-QR code (Style M3, ECC-Level M), offering 7 bytes with 15% redundancy as follows:

| byte [bit-Range MSB: LSB] | 6[7:0] + 5[7:4] | 5[3:0] | 4[7:0] + 3[7:0] | 2[7:0] + 1[7:0] | 0[7:0] |
|---|---|---|---|---|---|
| Length / bit | 12 | 4 | 16 | 16 | 8 |
| Value | Traffic Sign Type ID | Orientation | Location (Latitude) | Location (Longitude) | Security |
| Meaning | Country dependent list of valid unique traffic signs | Sign face orientation (0000b = N, 0001b = NNE, ..., 1000b = S, ..., 1111b = NNW) | *16 bit* floating point value encoding the location (latitude) of the sign. | *16 bit* floating point value encoding the location (longitude) of the sign. | Result of signing with a private key of bytes 6-1. |

A second traffic sign information may be configured for a medium distance, medium resolution, and medium information according to a Micro-QR-Code (Style M4, ECC-Level M), offering 13 bytes with 15% redundancy as follows:

| byte [bit-Range MSB: LSB] | 12[7:0] + 11[7:4] | 11[3:0] | 10[7:0] + 9[7:0] + 8[7:0] + 7[7:0] | 6[7:0] + 5[7:0] + 4[7:0] + 3[7:0] | 2[7:0] + 1[7:0] + 0[7:0] |
|---|---|---|---|---|---|
| Length / bit | 12 | 4 | 32 | 32 | 24 |
| Value | Traffic Sign Type ID | Orientation | Location (Latitude) | Location (Longitude) | Security |
| Meaning | Country dependent list of valid unique traffic signs | Sign face orientation (e.g. 0000b = N, 0001b = NNE, ..., 1000b = S, ..., 1111b = NNW) | 32 bit floating point value encoding the location (latitude) of the sign. | 32 bit floating point value encoding the location (longitude) of the sign. | Result of signing with a private key of bytes 12-3.8 |

A third traffic sign information may be configured for a small distance, high resolution, and high information density with 30 bytes with 15% redundancy as follows:

| byte [ bit-Range MSB:LSB] | 29[7:0] + 28[7:4] | 28[3:0] | 27[7:0] ... 24[7:0] | 23[7:0] ... 20[7:0] | 19[7:0] ... 16[7:0] |
|---|---|---|---|---|---|
| Length / bit | 12 | 4 | 32 | 32 | 32 |
| Value | Traffic Sign Type ID | Orientation | Location (Latitude) | Location (Longitude) | Future Use |
| Meaning | Country dependent list of valid unique traffic signs (e.g. each numeric speed limit has its own entry) | Sign face orientation (e.g. 0000b = N, 0001b = NNE, ..., 1000b = S, ..., 1111b = NNW) | 32 bit floating point value encoding the location (latitude) of the sign. | 32 bit floating point value encoding the location (longitude) of the sign. | For example, indication for which lane the sign is meant (relative position), installation date of the sign. |

| Byte [Bit-Range MSB:LSB] | 15[7:0] ... 10[7:0] | 9[7:0] ... 0[7:0] |
|---|---|---|
| Length / Bit | 48 | 80 |
| Value | Sign ID | Security |
| Meaning | Unique sign ID per sign (per country, region, ...) | Result of signing with a private key of Bytes 30-10. |

As shown in FIG. 6, the code may be embedded into the pixel locations that overlap the ring of the traffic sign. As shown by active pixels 614 and 624. This way, the human-readable part of the sign is unaffected and may be used to embed traffic sign information for machine readable traffic sign information. Image sensors of an ADAS/AD system may detect the embedded traffic sign information and use it for comparing encoded traffic sign information with the information displayed in human readable form.

ADAS/AD systems may perceive traffic signs and designate a bounding box. A traffic sign image may be divided into a pixel grid within the designated bounding box. The pixel grid within the bounding box may be defined independently from the resolution of an image captured by an ADAS/AD system's image sensors.

A code scheme for embedding traffic sign information may include different colors, polarization, or other contrast generating factors. A code scheme should be chosen to not affect traffic sign detection systems. For example, two stage code schemes for a European speed limit traffic sign (see FIG. 6 element 600) may be configured as described in the following table:

| # | State 1 | State 2 | Vehicle | Human |
|---|---------|---------|---------|-------|
| 1 | red | black | Contrast between states can be detected with cameras, such as RCCC cameras, used for traffic sign detection. | Human drivers may find the change in traffic sign appearance distracting. |
| 2 | red | different shade of red | Contrast between states may not be enough to be detectable in extreme lighting conditions. | Not distracting to human drivers. |
| 3 | red | different color | Contrast between states should be sufficient to be detected. RCCC and RGB cameras may be used in conjunction. | If the contrast in color between the two states is not too large, a human driver may not be distracted. |
| 4 | horizontally polarized red | vertically polarized red | May require an additional camera which includes a polarization filter. | Humans wearing Polarized sunglasses may be distracted. |

The code scheme does not necessarily need to be limited to two colors or states. For example, variants with three or even more colors or contrast mechanisms may encode more information. The states or colors chosen for a code scheme will ideally appear as noise to traffic sign detection systems, thus not affecting their detection rates.

The traffic sign information included in the embedded code may be protected by redundancy and verification information. For example, the verification information may be a check sum used to verify different traffic sign information. The data density of the traffic sign information may depend on the viewing angle range and an image sensor resolution. The traffic sign information may include a type of traffic sign, a numerical value, GPS coordinates, and/or a unique ID. The type of traffic sign may include a speed sign, or a stop sign, or any other type of traffic sign. The numerical value of a traffic sign may include the speed limit.

As the pixel grid of a traffic sign image increases more information can be embedded in the traffic sign display. As the distance between an image sensor and the traffic sign decreases, more information may be embedded in the traffic sign display.

Traffic sign images captured at larger viewing angle ranges may be divide into smaller pixels. For example, a higher resolution image may be captured at a larger viewing angle range as compared to a lower resolution image captured at a smaller viewing angle range. The higher resolution image may be divided into a larger number of smaller pixels as compared to a lower resolution image. The more pixels, the more traffic sign information may be embedded in the traffic sign information. The pixel grid, including pixel size and pixel number, depends on the position and angle of the ADAS/AD system's image sensors with respect to the front of the traffic sign.

Traffic signs may be configured to display imagery, such as a blank sign, for viewing angle ranges that can only be seen by cars in other traffic lanes for which the traffic sign information is not relevant. Alternatively, a single traffic sign may be configured to display different information for adjacent roads or lanes.

Traffic sign information may include information about their contextual meaning. For example, which lane the information is for, which traffic participants are addressed by the traffic sign, and an hourly validity. Traffic signs configured to display changing traffic sign information may be used in conjunction with traditional traffic signs.

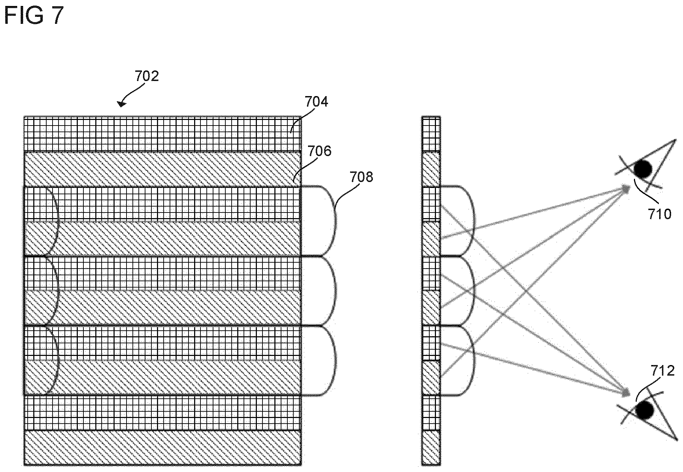

FIG. 7 shows an exemplary traffic sign configuration for displaying different traffic sign information. For example, traffic sign 600 may include an array of lenticular lenses 702. Two static images 704 and 706 may positioned under a lenticular lens 708. Static image 704 may be viewed at a detectable viewing angle range 712. Static image 706 may be viewed at a detectable viewing angle range 710. Lenticular lens array 702 may be expanded to work with more than two static images.

Traffic signs may use lenticular lenses to display different traffic sign information at different viewing angle ranges. Lenticular lenses are low cost and proven method of creating viewing angle dependent imagery. Lenticular lenses may also be combined with highly reflective retro-reflector foils often used in traffic signs.

Multiple static images may be placed under an array of lenticular lenses. For example, to display two static images, alternating portions of the two static images may be positioned under a lenticular lens. Each lens of the lens array may have different alternating portions of the two static images positioned under it. Each portion of the two static images appear at a respective viewing angle range. This principle may be extended to more than two static images.

One feature of lenticular lens arrays is that they are extruded 2D lens arrays. Therefore, images displayed from under a lenticular lens only changes when the viewing angle range changes from a single plane. The plane needs to be considered when planning the orientation of the traffic sign with respect to passing vehicles. The change in the display of traffic sign information should be detected by a passing vehicle. The orientation of the lenticular lens on the traffic signs may depend on the position of the traffic sign with respect to the road. For example, overhead or roadside traffic signs.

For example, a road side traffic sign may be configured to display different traffic sign information along a plane between the front of the traffic sign and vehicles approaching the traffic sign along a road. Other vehicles coming from a different direction or another road may not see the change in the traffic sign display or not see any traffic sign information at all. Similarly, overhead traffic signs may be configured to change the traffic sign information display for approaching vehicles.

Lenticular lenses have been proven to be compatible with electronic displays. This can be achieved using a high-resolution display and properly aligning the lenticular lens array in front of the high-resolution display.

Selecting the different viewing angle ranges may depend on the following factors: a relative change in traffic sign display depending on a vehicle speed, the separation and contrast between consecutive embedded codes, and resolution requirements imposed by ADAS/AD system image sensors.

For example, we may compare three viewing angle ranges. A traffic sign may display a first traffic sign information at 5 degrees. The traffic sign information may be associated with the lower resolution and a farther distance as compared to other viewing angle ranges. Therefore, the embedded code may include less information with respect to other traffic sign information. This viewing angle range may be perceived for a longer time than the other viewing angle ranges.

The traffic sign may display a second traffic sign information at 20 degrees. The traffic sign information may be associated with a resolution and distance in between the other viewing angle ranges. The embedded code may include more information than the traffic sign information displayed at the first viewing angle range, but less information than the traffic sign information displayed at the third viewing angle range. , medium resolution QR Code, for additional data (e.g. checksums, ID).

The traffic sign may display a third traffic sign information at 45 degrees. The traffic sign information may be associated with a higher resolution and greater distance as compared to the other viewing angle ranges. The embedded code may include more information than the traffic sign information displayed at the other viewing angle ranges.

The angles mentioned in the previous example are only examples, and the traffic sign display may display the same traffic sign information throughout a viewing angle range. Increases in displayed traffic sign information offers a more robust traffic sign information verification.

Alternatively, different traffic sign information may be displayed with a two-dimensional micro lens array. Micro lens arrays may be produced from inexpensive plastic materials. Micro lens arrays allow traffic sign information to be displayed in a conical space starting from the traffic sign surface and expanding outward from the traffic sign. Traffic signs may be individually optimized for their position over or along a road. For example, if the traffic sign in positioned near a curve.

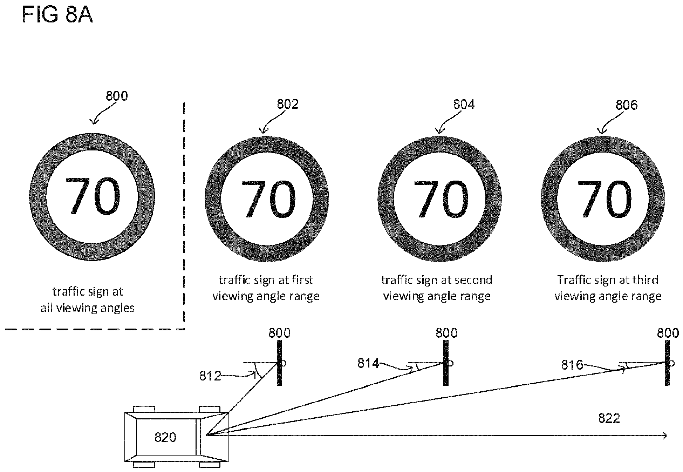

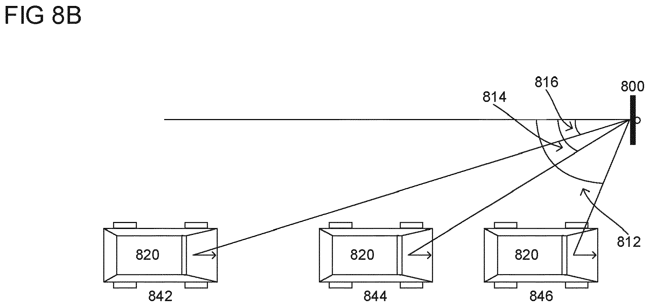

FIGs 8A and 8B show an exemplary traffic sign 800. FIG. 8A shows traffic sign 800 may appear the same to a human at all angles. However, traffic sign 800 may include three static traffic sign images 802, 804, and 806. Each traffic sign image may include traffic sign information. Traffic sign 800 may be configured to display different static traffic sign images at different detectable viewing angle ranges. As vehicle 820 is approaching traffic sign 800 in direction 822, image sensors may capture one or more images of traffic sign 800. For example, traffic sign 800 may be configured to display traffic sign image 802 at viewing angle range 816. Traffic sign 800 may be configured to display traffic sign image 804 at viewing angle range 814. Traffic sign 800 may be configured to display traffic sign image 806 at viewing angle range 812.

FIG. 8B shows a different perspective of vehicle 820 driving passed traffic sign 800. Vehicle 820 may include one or more image sensors to captures images of traffic sign 800. FIG. 8B shows vehicle 820 at different points in time as it approaches traffic sign 800. At first point in time 842, image sensors may capture a first image of traffic sign 800. At point in time 842 the image sensors may be at detectable viewing angle 816 with respect to traffic sign 800. Traffic sign 800 may be configured to display traffic sign image 802 at viewing angle range 816. Image sensors may capture traffic sign image 802. At second point in time 844, image sensors may capture a second image of traffic sign 800. At point in time 844 the image sensors may be at detectable viewing angle 816 with respect to traffic sign 800. Traffic sign 800 may be configured to display traffic sign image 804 at viewing angle range 814. Image sensors may capture traffic sign image 804. At third point in time 846, image sensors may capture a third image of traffic sign 800. At point in time 846 the image sensors may be at detectable viewing angle 812 with respect to traffic sign 800. Traffic sign 800 may be configured to display traffic sign image 806 at viewing angle range 812. Image sensors may capture traffic sign image 806.

As vehicle 820 approaches traffic sign 800 its image sensors may capture images at different distances. For example, image sensors may capture traffic sign image 802 at a farther distance relative the traffic sign image 804. Furthermore, image sensors may capture traffic sign image 804 at a farther distance relative the traffic sign image 806. Images captured at a farther distance may have a lower resolution as compared to traffic sign images captured at a closer distance. Traffic sign images with lower resolutions may contain less traffic sign information as compared to traffic sign images captured at a closer image. For example, traffic sign image 802 may have a lower resolution and less traffic sign information as compared to traffic sign image 804. Traffic sign image 804 may have a lower resolution and less traffic sign information as compared to traffic sign image 806.

Offline traffic sign verification may use progressive capture of traffic sign images which include traffic sign information. The traffic sign information captured is intended to increase credibility. The basic data contained in the traffic sign information can be made redundant, so that every embedded code contains a basic level of information, such as speed limit.

For example, a vehicle is moving with 200 km/h (55.56 m/s), resulting in 1.85 m of movement per frame if an image sensor captures 30 frames per second. Using lenticular lenses, the displayed traffic sign information codes may be visible over a viewing angle range. This range is modifiable and depends on the feature and size of the images behind the lenticular lens array.

For a first traffic sign information the change in the angle from the traffic sign relative to the movement of the vehicle is very small. Here, the minimum distance at which the sign can be detected, and the traffic sign information can be read is crucial. Assuming this is distance is 55.56 m, we may also assume that the centerline distance between the vehicle and the traffic sign is about 3 m. The initial angle is around 3.1 degrees, however, we may start from 0 degrees. Given the speed and the frame capture rate previously stated, we will acquire 30 frames until the vehicle passes the traffic sign. To capture ten frames for each of three different traffic sign information displayed, different traffic sign information may be displayed roughly every 18.5 m.

Based on the previous example, the following viewing angle ranges may be configured for the traffic sign:

Viewing angle range 1 => 0 degrees until 4.6 degrees
Viewing angle range 2 => 4.6 degrees until 9.2 degrees
Viewing angle range 3 => 9.2 degrees until 90 degrees

Calculated using the following equation:

$$d_{rangeEnd}(i) = \tan^{-1}\left(\frac{3m}{55.56m - i \cdot 18.5m}\right) \text{ where i = the viewing angle range.}$$

For example, i = 1 for viewing angle range 1.

All types of traffic signs may be configured to display traffic sign information at different detectable viewing angle ranges. For example, a speed limit sign may be configured to display the speed limit and the verification code at a first detectable viewing angle range. The speed limit sign may be configured to display the speed limit, GPS coordinates of the traffic sign, and the verification code at the second detectable viewing angle range.

If there are obstructions between an ADAS/AD system's image sensor and a traffic sign, the traffic sign's position can still be estimated until it is back in view. If, the obstruction is short, the ADAS/AD system may capture all the different traffic sign information displayed. Including redundancy within different traffic sign information may avoid missed information for longer obstructions.

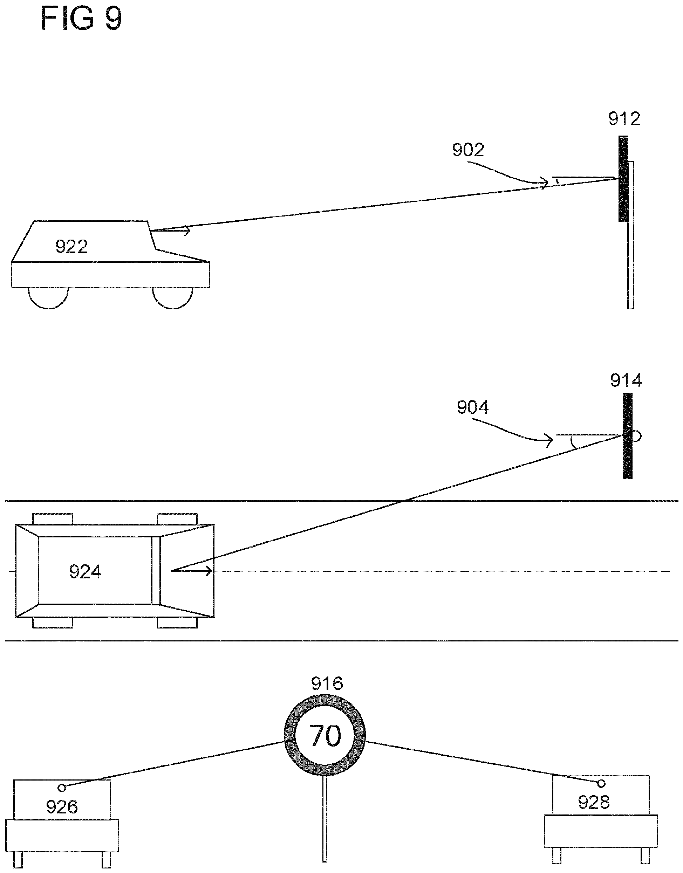

FIG. 9 shows an exemplary configuration for displaying traffic sign information at different detectable viewing angle ranges. For example, vehicle 922 approaches traffic sign 912. Angle 902 may be the angle between the center of the traffic sign display and an image sensor of vehicle 922. The traffic sign display may not be configured to display changes in traffic sign information at angle 902. However, traffic sign 914 may be positioned on the side of a road. Traffic sign 914 may be configured to display traffic sign information at viewing angle range 904. As vehicle 924 drives down and approaches traffic sign 914, image sensors of vehicle 904 may detect the changing traffic sign information at viewing angle range 904. Traffic sign 916 may be configured to display different traffic sign information at different angles. For example, vehicles 926 and 928 may approach traffic sign 916 at different viewing angle ranges. Traffic sign 916 may be configured to display a speed limit information to vehicle 926 and an animal crossing information to vehicle 928. Alternatively, traffic sign 916 may be configured to not display any information to one of the vehicles.

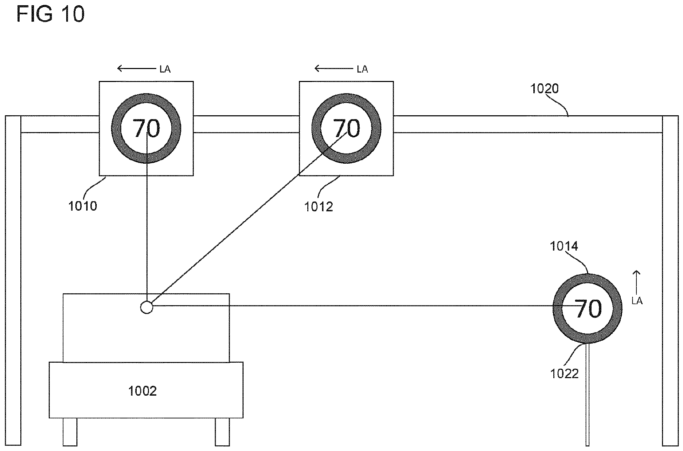

FIG. 10 shows an exemplary configuration for display traffic sign information from an overhead traffic sign. Traffic sign displays 1010, 1012, and 1014 may include a clamping structure. For example, clamping structure of traffic sign displays 1010 and 1012 may clamp to overhead structure 1020. Overhead structure may be positioned over a roadway. Traffic sign display 1010 may be configured to display traffic sign information to vehicle 1002 below traffic sign display 1010. Traffic sign display 1012 may be configured to display traffic sign information to vehicle 1002 below and to the side of traffic sign display 1012.

For example, overhead traffic signs may have to configure lenticular lenses at different viewing angle ranges as compared to roadside traffic signs. The viewing angle ranges of an overhead sign, may not work as a roadside traffic sign.

A clamping structure of traffic sign display 1014 may clamp to traffic sign post 1022. Traffic sign post 1022 may be positioned on a side of a road. Traffic sign display 1014 may be configured to display traffic sign information to vehicle 1002 as described in FIG. 9.

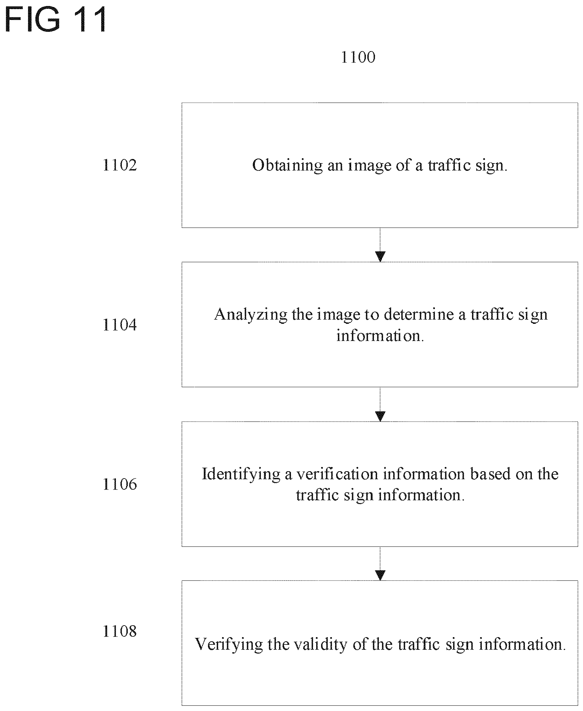

FIG. 11 shows exemplary method 1100 of verifying traffic sign information according to some aspects. As shown in FIG. 11, method 1100 includes obtaining an image of a traffic sign (stage 1102), analyzing the image to determine a traffic sign information (stage 1104), identifying a verification information based on the traffic sign information (stage 1106), and verifying the validity of the traffic sign information (stage 1108).

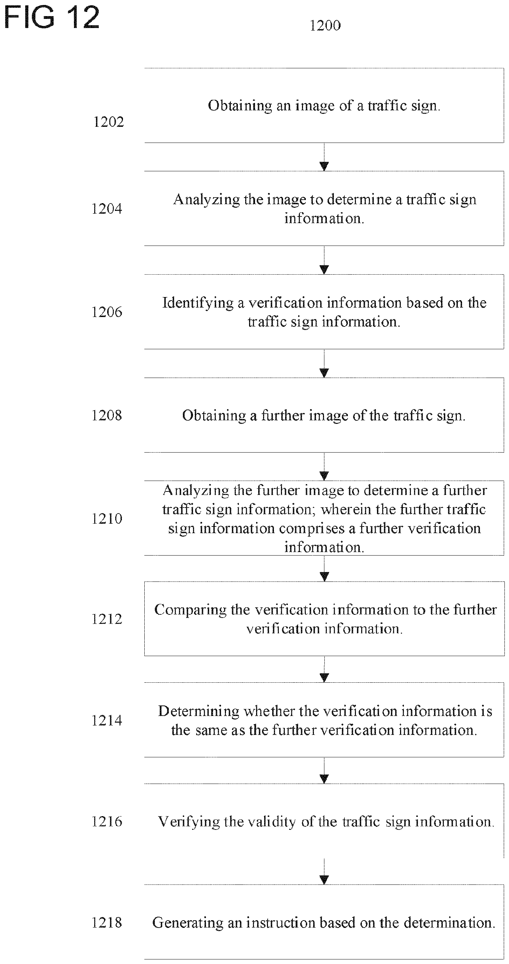

FIG. 12 shows exemplary method 1200 of verifying traffic sign information according to some aspects. As shown in FIG. 12, method 1200 includes obtaining an image of a traffic sign (stage 1202), analyzing the image to determine a traffic sign information (stage 1204), identifying a verification information based on the traffic sign information (stage 1206), obtaining a further image of the traffic sign (stage 1208), analyzing the further image to determine a further traffic sign information; wherein the further traffic sign information comprises a further verification information (stage 1210), comparing the verification information to the further verification information (stage 1212), determining whether the verification information is the same as the further verification information (stage 1214), verifying the validity of the traffic sign information (stage 1216), and generating an instruction based on the determination (stage 1218).

In the following, various aspects of the present disclosure will be illustrated

Example 1 is a traffic sign including a traffic sign display comprising a traffic sign information, wherein the traffic sign information includes a verification information to verify the validity of the traffic sign information.

In Example 2, the subject matter of Example 1 may optionally further include wherein the traffic sign display further comprises a first detectable viewing angle range and a second detectable viewing angle range; wherein the first detectable viewing angle range is configured to display the traffic sign information; wherein the second detectable viewing angle range is configured to display a further traffic sign information; and wherein the further traffic sign information comprises a further verification information to verify the validity of the traffic sign information.

In Example 3, the subject matter of Example 2 may optionally further include wherein the verification information is the same as the further verification information.

In Example 4, the subject matter of any one of Examples 1 to 3 may optionally further include wherein the traffic sign information comprises satellite-based coordinates of a traffic sign location.

In Example 5, the subject matter of any one of Examples 2 to 4 may optionally further include wherein the second detectable viewing angle range is configured to display a blank information.

In Example 6, the subject matter of any one of Examples 2 to 5 may optionally further include wherein the first detectable viewing angle range is configured to display the traffic sign information in a human readable format; and the second detectable viewing angle range is configured to display the further traffic sign information in the human readable format.

In Example 7, the subject matter of any one of claims 2 to 5 may optionally further include wherein the first detectable viewing angle range is configured to display the traffic sign information in a machine readable format, and the second detectable viewing angle range is configured to display the further traffic sign information in the machine readable format.

In Example 8, the subject matter of any one of Examples 2 to 7, may optionally further include wherein the first detectable viewing angle range is configured for a first display resolution and the second detectable viewing angle range is configured for a second display resolution.

In Example 9, the subject matter of Example 8, may optionally further include wherein the second display resolution is greater than the first display resolution.

In Example 10, the subject matter of any one of Examples 8 or 9 may optionally further include wherein the further traffic sign information comprises a larger amount of data than the traffic sign information.

In Example 11, the subject matter of Example 10 may optionally further include wherein the further traffic sign information comprises at least a portion of the data from the traffic sign information.

In Example 12, the subject matter of any one of Examples 2 to 11 may optionally further wherein second detectable viewing angle range is larger than the first detectable viewing angle range.

In Example 13, the subject matter of any one of Examples 2 to 12 may optionally further include wherein the second detectable viewing angle range is a ratio to the first detectable viewing angle range is a ratio.

In Example 14, the subject matter of any one of Examples 2 to 13 may optionally further include wherein the ratio is 4:3.

In Example 15, the subject matter of any one of Examples 2 to 13 may optionally further include wherein the traffic sign display comprises an electronic display.

In Example 16, the subject matter of Example 15 may optionally further include wherein the electronic display comprises light emitting diodes (LED).

In Example 17 , the subject matter of any one of Examples 2 to 11 may optionally further include wherein the traffic sign display is printed on a substrate.

In Example 18, the subject matter of any one of Examples 2 to 11 or 17 may optionally further include wherein the traffic sign display comprises a plurality of lenticular lenses.

In Example 19, the subject matter of any one of Examples 2 to 11 or 17 may optionally further include wherein the traffic sign display comprises an array of micro lenses.

Example 20 is a device including one or more processors configured to obtain an image of a traffic sign, analyze the image to determine a traffic sign information, identify a verification information based on the traffic sign information, and verify the validity of the traffic sign information.

In Example 21, the subject matter of Example 20 may optionally further include wherein verifying the validity of the traffic sign information comprises: comparing the verification information to a further verification information, and determining whether the verification information is the same as the further verification information.

In Example 22, the subject matter of any one of Examples 21 or 21, may optionally further include wherein the one or more processors are configured to generate an instruction based on the determination.

In Example 23, the subject matter of any one of Examples 20 to 22, may optionally further include wherein the one or more processors are further configured to obtain a further image of the traffic sign, and analyze the further image to determine a further traffic sign information, wherein the further traffic sign information comprises the further verification information.

In Example 24, the subject matter of any one of Examples 21 to 23 may optionally further include a memory storing the further verification information.

In Example 25, the subject matter of any one of Examples 21 to 23 may optionally further include a communication interface configured to receive the further verification information from a database.

In Example 26, the subject matter of any one of Examples 23 to 25 may optionally further include wherein the further image of the traffic sign comprises a higher resolution than the image of the traffic sign.

In Example 27, the subject matter of Example 26 may optionally further include wherein the further traffic sign information comprises a larger amount of data than the traffic sign information.

In Example 28, the subject matter of any one of Examples 26 or 27 may optionally further include wherein the further traffic sign information comprises at least a portion of the data from the traffic sign information.

In Example 29, the subject matter of any one of Examples 18 to 25 may optionally further include wherein the verification information and the further verification information are the same, and the instruction comprises a message that the traffic sign information is verified.

In Example 30, the subject matter of any one of Examples 21 to 29 may optionally further include wherein the verification information and the further verification information are not the same, and the instruction comprises a message that the traffic sign information is not verified.

In Example 31, the subject matter of any one of Examples 22 to 30 may optionally further include wherein the one or more processors are further configured to compare the traffic sign information to the further traffic sign information, and wherein the instruction is further based on the comparison of the traffic sign information and the further traffic sign information.

Example 32 is a device including a memory configured to store instructions, one or more processors coupled to the memory to execute the instructions stored in the memory, wherein the processors are configured to: implement a traffic sign verification model, wherein the verification comprises: obtaining an image of a traffic sign, analyzing the image to determine a traffic sign information, identifying a verification information based on the traffic sign information, and verifying the validity of the traffic sign information.

In Example 33, the subject matter of Example 32 may optionally further include wherein verifying the validity of the traffic sign information comprises: comparing the verification information to a further verification information, and determining whether the verification information is the same as the further verification information.

In Example 34, the subject matter of any one of Examples 32 or 33 may optionally further include wherein the one or more processors are configured to generate an instruction based on the determination.

Example 35 is a method including obtaining an image of a traffic sign, analyzing the image to determine a traffic sign information, identifying a verification information based on the traffic sign information, and verifying the validity of the traffic sign.

In Example 36, the subject matter of Example 35 may optionally further include wherein verifying the validity of the traffic sign information includes comparing the verification information to a further verification information, and determining whether the verification information is the same as the further verification information.

In Example 37, the subject matter of any one of Examples 35 or 36 may optionally further include generating an instruction based on the determination.

In Example 38, the subject matter of any one of Examples 35 to 37 may optionally further include obtaining a further image of the traffic sign, and analyzing the further image to determine a further traffic sign information, wherein the further traffic sign information comprises the further verification information.

In Example 39, the subject matter of any one of Examples 36 to 38 may optionally further include receiving the further verification information from a database.

In Example 40, the subject matter of any one of Examples 38 to 39 may optionally further include wherein the further image of the traffic sign comprises a higher resolution than the image of the traffic sign.

In Example 41, the subject matter of Example 40 may optionally further include wherein the further traffic sign information comprises a larger amount of data than the traffic sign information.

In Example 42, the subject matter of any one of Examples 40 or 41 may optionally further include wherein the further traffic sign information comprises at least a portion of the data from the traffic sign information.

In Example 43, the subject matter of any one of Examples 36 to 42may optionally further include wherein the verification information and the further verification information are the same, and the instruction comprises a message that the traffic sign information is verified.

In Example 44, of any one of Examples 36 to 42 may optionally further include wherein the verification information and the further verification information are not the same, and the instruction comprises a message that the traffic sign information is not verified.

In Example 45, the subject matter of any one of Examples 37 to 44 may optionally further include comparing the traffic sign information and the further traffic sign information,

wherein the instruction is further based on the comparison of the traffic sign information and the further traffic sign information.

Example 46 is a system including one or more devices according to Examples 20-34 configured to implement a method according to Examples 35-45.

Example 47 is a system including one or more devices according to Examples 1-19, and one or more devices according to Examples 20-34 configured to implement a method according to Examples 35-45.

Example 48 is one or more non-transitory computer readable media comprising programmable instructions thereon, that when executed by one or more processors of a device, cause the device to perform any one of the method of Examples 35-45.

Example 49 is a means for implementing any of the Examples 1-34.

While the above descriptions and connected figures may depict device components as separate elements, skilled persons will appreciate the various possibilities to combine or integrate discrete elements into a single element. Such may include combining two or more circuits for form a single circuit, mounting two or more circuits onto a common chip or chassis to form an integrated element, executing discrete software components on a common processor core, etc. Conversely, skilled persons will recognize the possibility to separate a single element into two or more discrete elements, such as splitting a single circuit into two or more separate circuits, separating a chip or chassis into discrete elements originally provided thereon, separating a software component into two or more sections and executing each on a separate processor core, etc.

It is appreciated that implementations of methods detailed herein are demonstrative in nature, and are thus understood as capable of being implemented in a corresponding device. Likewise, it is appreciated that implementations of devices detailed herein are understood as capable of being implemented as a corresponding method. It is thus understood that a device corresponding to a method detailed herein may include one or more components configured to perform each aspect of the related method.

All acronyms defined in the above description additionally hold in all Examples included herein.

## Claims

1. A traffic sign comprising:

   a traffic sign display comprising a traffic sign information,
   wherein the traffic sign information comprises a verification information to verify the validity of the traffic sign information.

2. The traffic sign of Claim 1,

   wherein the traffic sign display further comprises a first detectable viewing angle range and a second detectable viewing angle range;
   wherein the first detectable viewing angle range is configured to display the traffic sign information;
   wherein the second detectable viewing angle range is configured to display a further traffic sign information; and
   wherein the further traffic sign information comprises a further verification information to verify the validity of the traffic sign information.

3. The traffic sign of any one of Claims 1 and 2, wherein the verification information displayed at the first detectable viewing angle range as the further verification information displayed at the second detectable viewing angle range.

**4.** The traffic sign of any one of Claims 1 and 2, wherein the second detectable viewing angle range is configured to display a blank information.

**5.** The traffic sign of any one of Claims 1 and 2, wherein the first detectable viewing angle range is configured for a first display resolution and the second detectable viewing angle range is configured for a second display resolution.

**6.** A device comprising:
one or more processors configured to:

obtain an image of a traffic sign;
analyze the image to determine a traffic sign information; and
identify a verification information based on the traffic sign information, wherein the traffic sign information comprises a verification information to verify the validity of the traffic sign information.

**7.** The device of Claim 6,
wherein verifying the validity of the traffic sign information comprises:

comparing the verification information to a further verification information; and
determining whether the verification information is the same as the further verification information.

**8.** The device of any one of Claims 6 and 7,
wherein the one or more processors are configured to generate a vehicle control instruction based on the determination.

**9.** The device of any one of Claims 6 to 8,
wherein the one or more processors are further configured to

obtain a further image of the traffic sign; and
analyze the further image to determine a further traffic sign information, wherein the further traffic sign information comprises the further verification information.

**10.** The device of Claim 9, further comprising:
a memory storing the further verification information.

**11.** A method comprising:

obtaining an image of a traffic sign;
analyzing the image to determine a traffic sign information; and
identifying a verification information based on the traffic sign information, wherein the traffic sign information comprises a verification information to verify the validity of the traffic sign information.

**12.** The method of Claim 11,
wherein verifying the validity of the traffic sign information comprises:

comparing the verification information to a further verification information; and
determining whether the verification information is the same as the further verification information.

**13.** The method of any one of Claims 11 and 12, further comprising:
generating a vehicle control instruction based on the determination.

**14.** The method of any one of Claims 11 to 13, further comprising:

obtaining a further image of the traffic sign; and
analyzing the further image to determine a further traffic sign information, wherein the further traffic sign information comprises the further verification information.

**15.** The method of Claim 14, further comprising receiving the further verification information from a database.

# FIG 1

FIG 2

200

| 112 | 112 | 112 | 112 | 114 Position | 116 Measurement |

102

214 Data Acquisition Processor

216 Application Processor

218 Communication Processor

104 Memory

204 Map DB

206 User interfaces

108 RF

108 RF

108 RF

106

# FIG 3

# FIG 4

*Input from 112, 114, and/or 204*

302
Perception System

```
402
Segmentation

404
Object/Feature Association

406
Tracking

408
Classification
```

*To 304*

# FIG 5

500

502

**Traffic sign search**

Search for traffic signs in camera stream.

504

no new signs found

new sign found

506

510

**Traffic sign tracking**

Track traffic sign and decode sub-codes while passing by the sign.

**Decode and store sub-code**

Decode the sub-code and store it for later processing.

508

still the same sub-code

new sub-code detected

passed the sign

512

**Decode full sign data**

Decode all sub-codes, verify the data and submit results to relevant vehicle systems.

FIG 6

600

610
far distance & low viewing angle
(low resolution)

612 traffic sign
bounding box  622

614 active pixels  624
on sign

pixel grid in
bouding box  616
(e.g. 9x9)

620
close distance & high viewing angle
(high resolution)

pixel grid in
bouding box  626
(e.g. 18x18)

FIG 7

FIG 8A

800

70

traffic sign at
all viewing angles

802

70

traffic sign at first
viewing angle range

804

70

traffic sign at second
viewing angle range

806

70

Traffic sign at third
viewing angle range

800

812

814

800

816

800

820

822

FIG 8B

# FIG 9

FIG 10

# FIG 11

1100

1102

Obtaining an image of a traffic sign.

1104

Analyzing the image to determine a traffic sign information.

1106

Identifying a verification information based on the traffic sign information.

1108

Verifying the validity of the traffic sign information.

# FIG 12

1200

1202 | Obtaining an image of a traffic sign.

1204 | Analyzing the image to determine a traffic sign information.

1206 | Identifying a verification information based on the traffic sign information.

1208 | Obtaining a further image of the traffic sign.

1210 | Analyzing the further image to determine a further traffic sign information; wherein the further traffic sign information comprises a further verification information.

1212 | Comparing the verification information to the further verification information.

1214 | Determining whether the verification information is the same as the further verification information.

1216 | Verifying the validity of the traffic sign information.

1218 | Generating an instruction based on the determination.

# EP 4 006 872 A1

Europäisches
Patentamt

European
Patent Office

Office européen
des brevets

## EUROPEAN SEARCH REPORT

**Application Number**

EP 21 19 4764

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/279007 A1 (ZINNER HELGE [DE] ET AL) 12 September 2019 (2019-09-12) | 1,6-15 | INV. G08G1/0962 |
| Y | * abstract; figures * * paragraphs [0009] - [0014], [0017], [0018], [0026], [0034], [0036], [0037], [0053], [0056] * | 2-5 | |
| X | DE 10 2013 224824 A1 (BOSCH GMBH ROBERT [DE]) 11 June 2015 (2015-06-11) | 1,6,11 | |
| A | * abstract; figures * * paragraphs [0009], [0012], [0013], [0017] * | 2-5, 7-10, 12-15 | |
| X | WO 2018/178844 A1 (3M INNOVATIVE PROPERTIES CO [US]) 4 October 2018 (2018-10-04) | 1,6,11 | |
| A | * abstract; figures * * paragraphs [0003], [0004], [0026] - [0028], [0046] - [0047], [0050], [0057], [0083] - [0085], [0091] - [0094], [0110] * | 2-5, 7-10, 12-15 | |
| | | | TECHNICAL FIELDS SEARCHED (IPC) |
| X | WO 2018/064198 A1 (3M INNOVATIVE PROPERTIES CO [US]) 5 April 2018 (2018-04-05) | 1,6,11 | G08G |
| A | * abstract; figures * * paragraphs [0005], [0006], [0045], [4667], [0068], [0083], [0084] * | 2-5, 7-10, 12-15 | |
| Y | JP 2006 132173 A (THREE M INNOVATIVE PROPERTIES) 25 May 2006 (2006-05-25) * abstract; figures * * paragraphs [0001], [0002], [0004] - [0012] * | 2-5 | |

-----

-/--

The present search report has been drawn up for all claims

| Place of search | Date of completion of the search | Examiner |
|---|---|---|
| The Hague | 22 February 2022 | Roost, Joseph |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

page 1 of 2

Europäisches
Patentamt

European
Patent Office

Office européen
des brevets

## EUROPEAN SEARCH REPORT

**Application Number**

**EP 21 19 4764**

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | EP 0 203 752 A2 (MINNESOTA MINING & MFG [US]) 3 December 1986 (1986-12-03) * abstract; figures * * column 2, line 48 – column 3, line 38 * * column 5, line 43 – column 6, line 56 * ----- | 2-5 | |

**TECHNICAL FIELDS SEARCHED (IPC)**

The present search report has been drawn up for all claims

| Place of search | Date of completion of the search | Examiner |
|---|---|---|
| The Hague | 22 February 2022 | Roost, Joseph |

EPO FORM 1503 03.82 (P04C01)

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

                                                        

& : member of the same patent family, corresponding document

## ANNEX TO THE EUROPEAN SEARCH REPORT
## ON EUROPEAN PATENT APPLICATION NO.

EP 21 19 4764

This annex lists the patent family members relating to the patent documents cited in the above-mentioned European search report.
The members are as contained in the European Patent Office EDP file on
The European Patent Office is in no way liable for these particulars which are merely given for the purpose of information.

22-02-2022

| Patent document cited in search report | | Publication date | Patent family member(s) | | Publication date |
|---|---|---|---|---|---|
| US 2019279007 | A1 | 12-09-2019 | CN | 109154980 A | 04-01-2019 |
| | | | DE | 102016208621 A1 | 23-11-2017 |
| | | | EP | 3459006 A1 | 27-03-2019 |
| | | | JP | 6813595 B2 | 13-01-2021 |
| | | | JP | 2019522260 A | 08-08-2019 |
| | | | US | 2019279007 A1 | 12-09-2019 |
| | | | WO | 2017198743 A1 | 23-11-2017 |
| DE 102013224824 | A1 | 11-06-2015 | NONE | | |
| WO 2018178844 | A1 | 04-10-2018 | CN | 110462700 A | 15-11-2019 |
| | | | EP | 3602515 A1 | 05-02-2020 |
| | | | JP | 2020515964 A | 28-05-2020 |
| | | | KR | 20190133039 A | 29-11-2019 |
| | | | WO | 2018178844 A1 | 04-10-2018 |
| WO 2018064198 | A1 | 05-04-2018 | CN | 109791623 A | 21-05-2019 |
| | | | EP | 3520030 A1 | 07-08-2019 |
| | | | JP | 2020502612 A | 23-01-2020 |
| | | | KR | 20190060798 A | 03-06-2019 |
| | | | US | 2020034590 A1 | 30-01-2020 |
| | | | WO | 2018064198 A1 | 05-04-2018 |
| JP 2006132173 | A | 25-05-2006 | NONE | | |
| EP 0203752 | A2 | 03-12-1986 | AT | 79182 T | 15-08-1992 |
| | | | AU | 589173 B2 | 05-10-1989 |
| | | | CA | 1250952 A | 07-03-1989 |
| | | | CA | 1263264 A | 28-11-1989 |
| | | | DE | 3686293 T2 | 28-01-1993 |
| | | | EP | 0203752 A2 | 03-12-1986 |
| | | | JP | 2637952 B2 | 06-08-1997 |
| | | | JP | S61261701 A | 19-11-1986 |
| | | | KR | 860009309 A | 22-12-1986 |
| | | | US | 4688894 A | 25-08-1987 |
| | | | US | 4691993 A | 08-09-1987 |

EPO FORM P0459

For more details about this annex : see Official Journal of the European Patent Office, No. 12/82